# EUROPÄISCHE PATENTANMELDUNG

(11) **EP 4 422 360 A1**
(43) Veröffentlichungstag der Anmeldung: **28.08.2024**
(21) Anmeldenummer: 23158562.1
(22) Anmeldetag: 24.02.2023
(51) Int. Cl.: H05K 1/02, H05K 1/18, H05K 1/11

(54) **VERBINDUNGSEINRICHTUNG**

(71) Anmelder: Erbe Elektromedizin GmbH, 72072 Tübingen (DE)
(72) Erfinder: Hatzfeld, Falk, 72072 Tuebingen (DE)
(74) Vertreter: Rüger Abel Patentanwälte PartGmbB

(57) **Zusammenfassung**

Die erfindungsgemäße Buchsenanordnung umfasst ein Buchsengehäuse (12) und einen darin angeordneten Buchseneinsatz (22), der vorzugsweise aus einer Mehrlagenleiterplatte erzeugt ist. Der Buchseneinsatz (22) enthält einander gegenüberliegende Kontaktelemente (37, 38), die jeweils von dem Leiterplattenmaterial gehalten sind. Die auf die Kontaktelemente (37, 38) einwirkenden mechanischen Kräfte beim Einstecken eines Steckkontakts werden über das Leiterplattenmaterial auf die Gehäuseteile (13, 14) übertragen und von diesen aufgenommen.

Mit diesem erfindungsgemäßen Konzept lassen sich auf sehr einfache Weise sehr zuverlässig arbeitende Buchsenanordnungen bereitstellen, die neben ihrer eigentlichen Funktion der elektrischen Verbindung eines medizinischen Instruments mit einem speisenden Gerät weitere Funktionen übernehmen können, wie Schutzfunktionen oder Kontrollfunktionen zum Beispiel auf das korrekte Einstecken von Steckern oder eine informationstechnische Kommunikation mit diesen über Kontakte oder NFC-Chips oder dergleichen.

## Beschreibung

Die Erfindung betrifft eine Verbindungseinrichtung insbesondere für elektrische Anschlüsse an Geräten zur Verbindung mit und Versorgung von medizinischen Instrumenten, zur Verbindung von Geräten untereinander oder auch zur Verbindung von Geräten mit anderen Komponenten.

Zur elektrischen Verbindung von Geräten, wie beispielsweise Laptops, mit anderen elektrischen Einrichtungen sind Buchsen bekannt, die aus gegeneinander beweglichen Komponenten bestehen. Beispielsweise offenbart die US 2007/0190862 A1 eine Buchse, die mit einer beweglichen Wand ausgestattet ist, so dass sich die Buchse beim Schließen des Laptops in eine abgeflachte Form überführt.

Aus der CN 104064900 A und der CN 202423682 U sind zudem faltbare Steckdosenleisten bekannt.

Die DE 10 2014 105 224 A1 offenbart ein Gerät mit einem Gehäuse und einer darin angeordneten Leiterplatte, die mit elektronischen Komponenten versehen ist. Die Leiterplatte weist mehrere gegeneinander abwinkelbare Bereiche auf.

Bei der Versorgung medizinischer Instrumente kommt es auf eine sichere Übertragung von elektrischer Leistung zu dem Instrument und gegebenenfalls auch auf verlässliche Übertragung von Signalen an, die von dem Instrument stammen. Es ist Aufgabe der Erfindung, dies mit modernen Fertigungsmethoden und geringem Aufwand zu erreichen.

Diese Aufgabe wird mit der Buchsenanordnung nach Anspruch 1 gelöst:
Die erfindungsgemäße Buchsenanordnung weist ein Buchsengehäuse auf, in welchem ein Buchseneinsatz angeordnet ist. Der Buchseneinsatz besteht aus einem flächigen an dazu vorgesehenen Biegestellen gefalteten Isoliermaterial mit darauf und/oder darin angeordneten elektrischen Leitern.

Das Isoliermaterial kann ein ebener, plattenartiger Körper sein, wie beispielsweise Leiterplattenmaterial, wie es sonst zur Herstellung elektrischer und elektronischer Schaltungen genutzt wird. Beispielsweise kann es sich um ein Kunststoffmaterial, ein faserverstärktes Kunststoffmaterial oder anderweitige elektrisch isolierende Materialien handeln. Die Leiter können auf zumindest einer Seite des plattenartigen Isoliermaterials und/oder im Körper desselben, d.h. in einer Zwischenebene angeordnet sein. Das Isoliermaterial kann ein oder mehrere Leiterebenen aufweisen. Damit können verschiedene elektrische Funktionen erbracht und miteinander kombiniert werden. Beispielsweise kann eine Leiterebene als Abschirmung dienen, während andere Leiterebenen zum elektrischen Anschluss von Kontakten und/oder elektrischen oder elektronischen Bauelementen dienen, die in oder an dem Isoliermaterial angebracht sein können.

Das Isoliermaterial kann eine oder mehrere Kontaktelemente, beispielsweise Kontaktfedern, Kontaktlamellen, Kontaktklemmen oder dergleichen tragen, die elektrisch mit einem oder mehreren Leitern des Buchseneinsatzes verbunden sind. Die Leiter des Buchseneinsatzes sind vorzugsweise dazu eingerichtet, die Kontaktelemente direkt mit Buchsenanschlüssen zu verbinden. Die Buchsenanschlüsse können ihrerseits als Steckkontakte, beispielsweise von dem Isoliermaterial getragene Steckkontaktfelder, ausgebildet sein. Bedarfsweise können zwischen den Kontaktelementen und/oder den Buchsenanschlüssen elektrische Bauelemente angeordnet und wirksam sein, wie beispielsweise Widerstände, Dioden, Kondensatoren oder aktive Bauelemente wie elektronische Schalter oder elektronische Schaltkreise. Der Buchseneinsatz kann elektrische oder elektronische Schaltungen tragen, die sowohl mit den Kontaktelementen als auch mit den Buchsenanschlüssen verbunden sind. Der Buchseneinsatz kann auch elektrische oder elektronische Schaltungen tragen, die nur mit den Kontaktelementen oder mit den Buchsenanschlüssen verbunden sind.

Die an dem Buchseneinsatz vorgesehenen Biegestellen sind vorzugsweise linienförmige Bereiche, die wiederum vorzugsweise entlang von Geraden verlaufend ausgebildet sind. Damit ist eine Abwinkelung verschiedener Bereiche des ansonsten steifen, plattenförmigen Isoliermaterials ohne Verwölbung desselben möglich. Das Isoliermaterial weist dazu wenigstens zwei parallele Biegestellen auf, an denen das Isoliermaterial vorzugsweise rechtwinklig abgewinkelt ist. Auf diese Weise kann sichergestellt werden, dass der Buchseneinsatz in dem Buchsengehäuse zwei parallel zueinander gehalten und sich somit im Abstand gegenüberliegende Bereiche aufweist. Der so gebildete Zwischenraum kann zur Aufnahme von Steckkontakten eines Kontaktsteckers, beispielsweise eines medizinischen Instruments, dienen. Kontaktelemente wie Kontaktfedern oder dergleichen können an den beiden einander im Abstand gegenüber liegenden Bereichen des Isoliermaterials angeordnet sein.

Ist das Isoliermaterial als Leiterplatte ausgebildet, kann eine Steckererkennung vorgesehen sein. Diese kann z.B. dadurch gebildet werden, dass eine auf der Leiterplatte angeordnete elektronische Schaltung eine Testspannung oder einen Teststrom an die betroffenen Kontaktelemente anlegt, so dass festgestellt werden kann, ob die Kontaktelemente durch ein Steckerelement miteinander verbunden sind. Es ist darüber hinaus möglich, an dem Leiterplattenmaterial, insbesondere den beiden einander gegenüberliegenden Bereichen desselben, einen oder mehrere Kontakte anzuordnen, die im Ruhezustand miteinander in Berührung stehen und beim Einstecken eines Steckers durch einen Isolierkörper voneinander getrennt werden. Auch können Lichtschranken oder ähnliche Steckererkennungsmittel, NFC-Chips zur Steckeridentifikation oder dergleichen auf einfache und komfortable Weise auf oder in dem Isoliermaterial angeordnet oder in dieses integriert werden. Damit eröffnet das erfindungsgemäße Konzept einen weiten Bereich von Entwicklungsmöglichkeiten von elektrisch und mechanisch robusten Buchsenanordnungen, die zahlreiche sicherheitsrelevante Zusatzfunktionen erfüllen.

Das Isoliermaterial kann auch Biegestellen aufweisen, die nicht parallel zueinander orientiert sind und auf diese Weise einen Innenraum nicht nur drei- oder vierseitig, sondern auch fünfseitig umschließen. Dies kann zur Erweiterung des Funktionsumfangs genutzt werden.

Die Biegestellen können durch in dem Isoliermaterial ausgebildete Nuten, das heißt Schwächungszonen gebildet sein, in denen die Steifigkeit des Isoliermaterials in Folge der lokalen Verringerung der Dicke desselben lokal reduziert ist. Der verbleibende geschwächte Bereich des Isoliermaterials kann elastisch oder auch plastisch verformbar sein. Er kann eine Art Filmscharnier bilden. Vorzugsweise sind eine, mehrere oder alle Biegestellen in dem Isoliermaterial lediglich einseitig ausgebildet, so dass an der nicht genuteten Seite des Isoliermaterials angeordnete Leiter an der Biegestelle nicht unterbrochen sind. Damit ist eine elektrische Verbindung zwischen verschiedenen Bereichen des plattenförmigen Isoliermaterials möglich, so dass der Buchseneinsatz als räumliche Leiterplatte zur Kontaktierung aller vorhandenen Kontakte und bedarfsweise auch zum Betrieb elektrischer Komponenten und Bauelemente genutzt werden kann.

Es ist möglich, das Isoliermaterial als nahtlose, einstückige, ebene Platte mit Schwächungszonen auszubilden, die die gewünschten Biegestellen definieren. Alternativ ist es möglich, eine, mehrere oder alle Biegestellen durch einen flexiblen Leiterträger zu bilden, der an den Biegestellen voneinander separierte Bereiche des Isoliermaterials miteinander mechanisch und/oder elektrisch verbindet. Solche flexiblen Leiterträger können auch dazu genutzt werden, den Buchseneinsatz elektrisch mit anderen Komponenten eines elektrischen Geräts lösbar oder unlösbar zu verbinden.

Der Buchseneinsatz kann eine oder mehrere Aussparungen oder sonstige Öffnungen aufweisen, die von einem oder mehreren Vorsprüngen des Buchsengehäuses oder sonstigen Führungskörpern durchgriffen sind. Ein solcher Führungskörper kann beispielsweise als Steckerführung, Stiftführung oder dergleichen ausgebildet sein, um eine Funktion der Steckerführung oder dergleichen zu übernehmen.

Weitere Einzelheiten vorteilhafter Ausführungsformen der Erfindung sind Gegenstand der Zeichnung sowie der zugehörigen Beschreibung oder von Unteransprüchen. In der Zeichnung zeigen:
Figur 1 eine erfindungsgemäße Buchsenanordnung anhand seines Buchsengehäuses in schematisierter, perspektivischer Darstellung,
Figur 2 einen Teil des Buchsengehäuses nach Figur 1, in gleicher Perspektive,
Figur 3 ebenes plattenförmiges Isoliermaterial zur Bereitstellung eines Buchseneinsatzes, in Draufsicht,
Figur 4 das Isoliermaterial nach Figur 3, teilweise aufgerichtet zur Bildung eines Buchseneinsatzes,
Figur 5 einen Eckbereich des Buchseneinsatzes nach Figur 4, in vergrößerter Vorderansicht,
Figur 6 einen Buchseneinsatz wie in Figur 5, jedoch in abgewandelter Ausführungsform,
Figur 7 die Buchsenanordnung nach Figur 1 in ausschnittsweiser vertikaler Schnittdarstellung,
Figur 8 das Isoliermaterial mit mehreren Leiterebenen und einem darauf angeordneten elektronischen Bauelement und
Figur 9 eine Darstellung der Buchsenanordnung ähnlich Figur 5, in vergrößerter Darstellung.

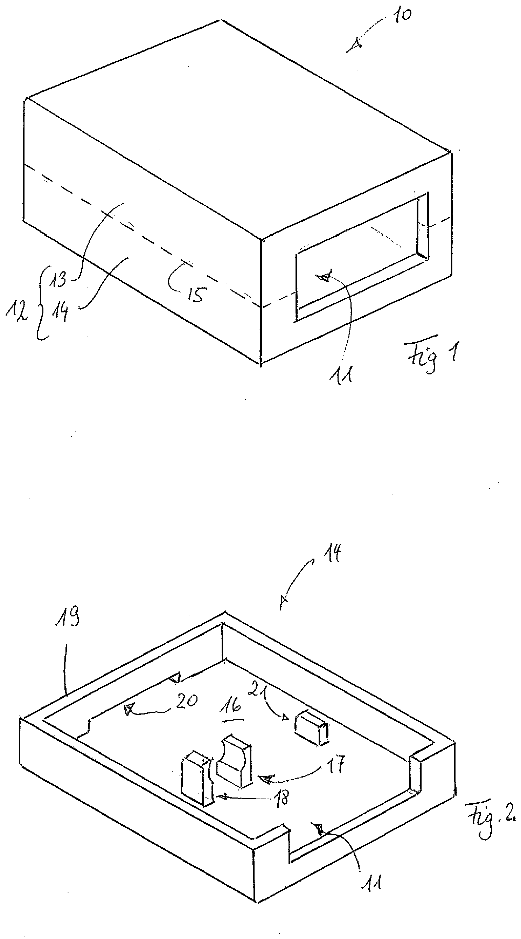

In Figur 1 ist die erfindungsgemäße Buchsenanordnung 10 veranschaulicht, die Teil eines elektrischen Geräts sein kann. Bei dem Gerät kann es sich insbesondere um ein Gerät zur Speisung medizinischer Instrumente handeln, die einen nicht weiter veranschaulichten Stecker aufweisen, der zur Kontaktierung des Instruments dient. Ein solcher Stecker ist bei einer Öffnung 11 in die Buchsenanordnung 10 einzuführen.

Die Buchsenanordnung kann als Teil eines Gerätegehäuses oder als gesondertes Bauteil ausgebildet sein. Sie umfasst ein Buchsengehäuse 12, das einen oberen Gehäuseteil 13 und einen unteren Gehäuseteil 14 umfasst. Bei dem in Figur 1 veranschaulichten Buchsengehäuse stoßen die Gehäuseteile 13, 14 an einer Mittelebene bzw. Trennlinie 15 aneinander. Die Trennung in oberen und unteren Gehäuseteil 13 und 14 kann jedoch auch an anderer Stelle oder mit anderer Ausrichtung erfolgen, so dass das Buchsengehäuse 12 vertikal in einen rechten und einen linken Gehäuseteil oder in einen vorderen und einen hinteren Gehäuseteil unterteilt ist. Ebenso gut kann das Buchsengehäuse 12 aus mehreren Gehäuseteilen bestehen oder auch einstückig ausgebildet sein. Im letztgenannten Fall kann es beispielsweise an seiner der Öffnung 11 gegenüberliegenden Rückseite offen sein.

Figur 2 zeigt den unteren Gehäuseteil 14 gesondert mit abgenommenem oberem Gehäuseteil. Wie ersichtlich, kann der von den Gehäuseteilen 13, 14 umschlossene Innenraum mit Führungskörpern 17, 18 oder anderen von der Innenseite des Gehäuseteils 14 in den Innenraum 16 ragenden Teilen versehen sein. Die Führungskörper 17, 18 können beispielsweise zur Führung von Kontaktstiften des nicht weiter veranschaulichten Steckers oder zu anderen Zwecken dienen. Sie können mit den Gehäuseteilen 13, 14 einstückig ausgebildet oder auf andere Weise an den Gehäuseteilen 13, 14 angebracht sein.

Der Gehäuseteil 14 (und/oder der Gehäuseteil 13) können an geeigneter Stelle, beispielsweise an der Rückseite 19, mit einer Anschlussöffnung 20 versehen sein, die zum Beispiel als flacher Schlitz ausgebildet sein kann. Au-ßer den Führungskörpern 17, 18 können an dem Gehäuseteil 14 auch andere Funktionselemente 21 beispielsweise in Gestalt von nach innen ragenden Vorsprüngen vorgesehen sein.

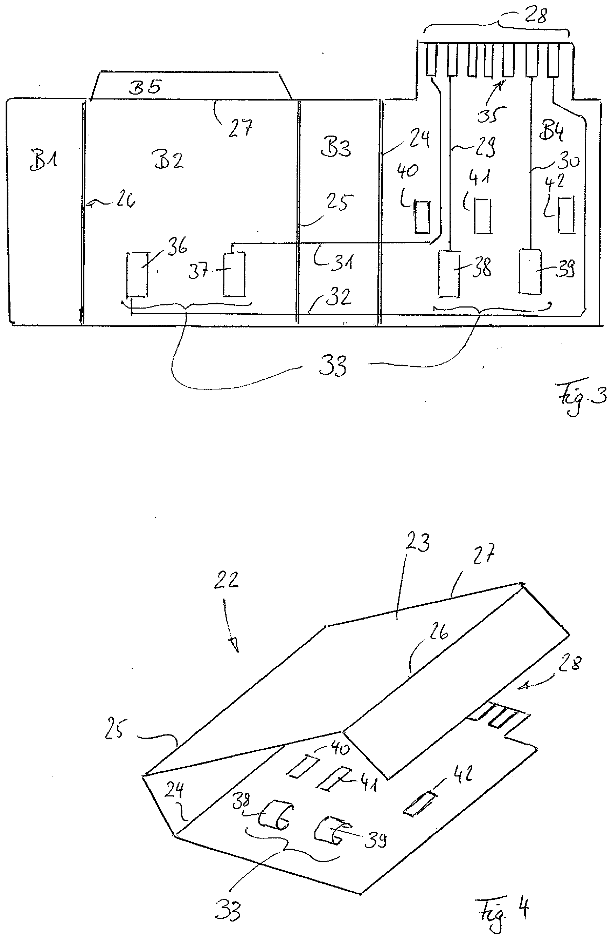

Zu der erfindungsgemäßen Buchsenanordnung 10 gehört ein Buchseneinsatz 22, der von dem Buchsengehäuse 12 aufgenommen ist. Der Buchseneinsatz 22 ist in Figur 4 gesondert veranschaulicht. Wie ersichtlich ist der Buchseneinsatz 22 aus einem steifen, plattenartigen Isoliermaterial 23 ausgebildet, das entlang mehrerer, vorzugsweise gerader, linienförmiger Biegestellen 24 bis 27 abwinkelbar ist. Es kann sich um Leiterplattenmaterial handeln.

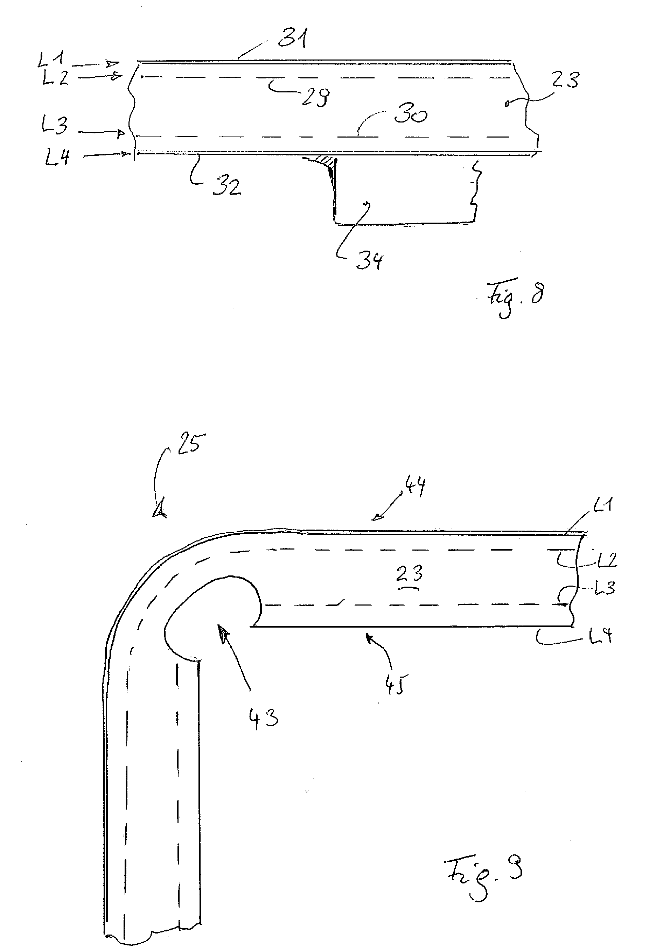

Figur 3 veranschaulicht die Herstellung des Buchseneinsatzes 22, ausgehend von einem zunächst vorzugsweise ebenen, flachen Isoliermaterial, wie beispielsweise Leiterplattenmaterial. Dieses Isoliermaterial besteht vorzugsweise aus Kunststoff, beispielsweise einem faserverstärkten Kunststoff und enthält in mindestens einer Ebene L1, L2, L3, L4 Leiterzüge 29, 30, 31, 32. Diese Leiterzüge 29 bis 32 können dazu dienen, die Buchsenanschlüsse 28 mit Dosenkontakten 33 zu verbinden, die zur Kontaktierung des in die Buchsenanordnung 10 einzusteckenden Steckers dienen. Die Leiterzüge 29 bis 32 sind in Figur 3 in einer einzigen Ebene veranschaulicht. Wie Figur 8 andeutet, können die Leiterzüge 29 bis 32 sowie auch weitere andere Leiterzüge auch in verschiedenen Leiterebenen L1, L2, L3, L4 angeordnet sein, die zum Beispiel auf den Flachseiten des Isoliermaterials 23 oder auch im Körper desselben angeordnet sind. Die Leiterzüge sind vorzugsweise Leiterzüge aus Kupfer oder einem anderen Metall. Das von den Leiterzügen gebildete Leitungsmuster kann auch zur Kontaktierung elektronischer Schaltungen dienen, die zum Beispiel elektrisch oder elektronische Bauelemente 34 enthalten, die auf dem Isoliermaterial 23 platziert sein können.

Die Buchsenanschlüsse 28 können wie in Figur 3 dargestellt durch Steckkontaktfelder 35 gebildet sein, die auf einem Leiterplattenvorsprung ausgebildet sind, der zum Beispiel durch die Anschlussöffnung 20 des Gehäuseteils 14 gesteckt werden kann. Die Dosenkontakte 33 können mehrere Kontaktelemente 36 bis 39 umfassen, die zum Beispiel wie in Figur 4 angedeutet durch Kontaktfedern gebildet sind.

Außerdem kann das Isoliermaterial 23 ein oder mehrere Durchbrüche 40, 41, 42 aufweisen, durch die sich die Führungskörper 17, 18 oder das sonstige Funktionselement 21 erstrecken können.

Aus Figur 9 ist insbesondere die Biegestelle 25 des Isoliermaterials 23 ersichtlich. Die übrigen Biegestellen 24, 26, 27 können ähnlich oder gleich ausgebildet sein. Das Isoliermaterial 23 ist zur Ausbildung der Biegestelle 25 mit einer Nut 43 versehen, bei der das Isoliermaterial 23 deutlich geschwächt ist. Vorzugsweise ist die zwischen den beiden Flachseiten 44, 45 zu messende Dicke um mehr als die Hälfte reduziert, so dass die Biegestelle 25 im Vergleich zu dem ansonsten als eher steif anzusehende Isoliermaterial 23 flexibel ist. An der Biegestelle kann das Isoliermaterial plastisch oder elastisch verformbar sein.

Vorzugsweise ist die Nut 43 dem Innenraum 16 zugewandt. Weiter vorzugsweise unterbricht die Nut 43 nicht alle Leiterebenen L1 bis L4. Insbesondere können die Leiterebenen L1, L2 erhalten bleiben, so dass eine elektrische Verbindung zwischen verschiedenen durch die Biegestellen 24 bis 27 voneinander getrennten Bereiche B4 bis B5 des beispielsweise aus Mehrlagenleiterplatten ausgebildeten Buchseneinsatzes möglich ist (Figur 3).

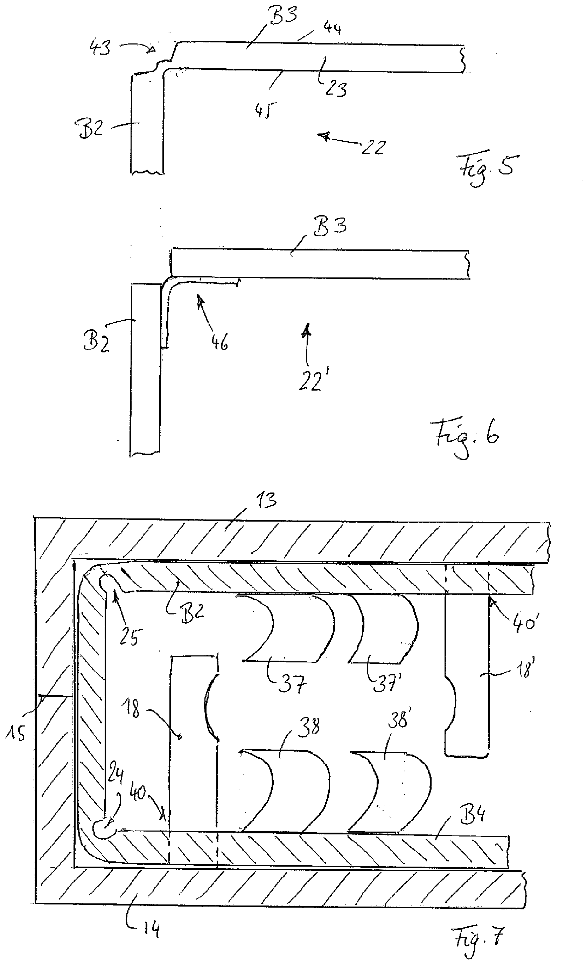

Prinzipiell ist es auch möglich, die Nut 43 an der Außenseite des Buchseneinsatzes 22 anzubringen, wie es in Figur 5 veranschaulicht ist. In diesem Fall wird wenigstens die Leiterebene L4, vorzugsweise aber auch die Leiterebene L3 erhalten, um wiederum eine elektrische Verbindung zwischen den verschiedenen Bereichen B1 bis B5 des Buchseneinsatzes 22 zu ermöglichen.

Wie Figur 6 veranschaulicht, kann eine solche Eckverbindung auch durch gesonderte Eckverbinder 46 erbracht werden. Während die Buchseneinsätze 22, bei denen die Biegestellen 24 bis 27 durch Nuten gebildet sind, nahtlos einteilig sind, können Buchseneinsätze 22' nach Figur 6 aus verschiedenen Teilen bestehen. Beispielsweise können die Bereiche B2, B3 usw. voneinander zunächst gesondert bereitgestellt und später über Eckverbinder 46 verbunden werden. Die Eckverbinder 46 können beispielweise aus flexiblem Material, wie es als flexible Leiterplatte bekannt ist, oder ähnlichem bestehen. Außerdem ist es möglich, einen Buchseneinsatz 22 bereitzustellen, bei dem die Biegestellen 24 bis 27 auf verschiedene der hier offenbarten Arten erzeugt sind.

Figur 7 veranschaulicht eine leicht abgewandelte Ausführungsform der Buchsenanordnung 10. Die Kontaktelemente 37, 38, die an den Bereichen B4, B2 der Leiterplatte vorgesehen sind, liegen sich gegenüber, so dass sie zwischen einander einen Kontaktstift aufnehmen können. Außerdem durchragt der Führungskörper 18 den Durchbruch 40. Ebenso kann ein Führungskörper 18' des oberen Gehäuseteils 13 eine entsprechende Öffnung 40' des Bereichs B2 durchragen. Außerdem können zwischen den beiden Führungskörpern 18, 18` weitere Kontaktelemente 37', 38' vorgesehen sein. Über die Biegestellen 24, 25 hinweg, ist eine elektrische Verbindung durch geeignet angeordnete Leiterzüge vorgesehen. Das als Leiterplatte dienende Isoliermaterial 23 kann zudem weitere Elemente, wie zum Beispiel elektronische oder elektrische Bauelemente enthalten. Diese können zum Beispiel dazu dienen, einen Stromfluss zwischen gegenüberliegenden Kontaktelementen 37, 38 zu registrieren, um auf das Vorhandensein oder nicht Vorhandensein von Kontaktpins zu schließen. Es können weitere elektrische Funktionen oder Sicherheitsfunktionen realisiert sein, beispielsweise durch als Schmelzsicherung dienende Leiterzüge oder Bauelemente zum elektrischen Schutz, beispielsweise Überspannungsschutz oder Leiterbereiche zur elektrischen Abschirmung und dergleichen Funktionen mehr.

Die insoweit beschriebene Buchsenanordnung 10 kann auf einfache Weise aus vorgefertigten Gehäuseteilen 13, 14 und einer entsprechend geformten ein- oder mehrlagigen Leiterplatte aus dem Isoliermaterial 23 und den Leiterzügen erzeugt werden. Die mit dem gewünschten Leitungsmuster versehene Leiterplatte wird dazu mit den nötigen Kontaktelementen 36 bis 39, beispielsweise Kontaktfedern, bestückt. Zuvor oder danach können die Biegestellen 24 bis 27 erzeugt werden, indem entsprechende Schwächungszonen, beispielsweise in Gestalt von Nuten, vorgesehen werden. Alternativ können die Bereiche B1 bis B5 separat bereitgestellt und mit flexiblen Verbindungselementen nach dem Vorbild der Figur 6 mechanisch und elektrisch untereinander verbunden werden. Die so bereitgestellte und bestückte Leiterplatte nach Figur 3 wird dann an den Biegestellen 24 bis 27 gefaltet, wie es Figur 4 andeutet und in den unteren Gehäuseteil 14 eingelegt, wobei die Führungskörper 17, 18 oder sonstige Funktionselemente 21, die in der Leiterplatte vorgesehene Durchbrüche oder Öffnung 40 - 42 durchgreifen. Zum Schlie-ßen der Gehäuseanordnung 10 wird der obere Gehäuseteil 13 auf den unteren Gehäuseteil 14 aufgesetzt und mit diesem durch ein geeignetes Verfahren beispielsweise Kleben, Ultraschallschweißen oder durch Schraub- oder Rastverbindung oder andere Verbindungsmittel verbunden, womit die Buchsenanordnung 10 funktionsfähig ist.

Die erfindungsgemäße Buchsenanordnung umfasst ein Buchsengehäuse 12 und einen darin angeordneten Buchseneinsatz 22, der vorzugsweise aus einer Mehrlagenleiterplatte erzeugt ist. Der Buchseneinsatz 22 enthält einander gegenüberliegende Kontaktelemente 37, 38, die jeweils von dem Leiterplattenmaterial gehalten sind. Die auf die Kontaktelemente 37, 38 einwirkenden mechanischen Kräfte beim Einstecken eines Steckkontakts werden über das Leiterplattenmaterial auf die Gehäuseteile 13, 14 übertragen und von diesen aufgenommen.

Mit diesem erfindungsgemäßen Konzept lassen sich auf sehr einfache Weise sehr zuverlässig arbeitende Buchsenanordnungen bereitstellen, die neben ihrer eigentlichen Funktion der elektrischen Verbindung eines medizinischen Instruments mit einem speisenden Gerät weitere Funktionen übernehmen können, wie Schutzfunktionen oder Kontrollfunktionen zum Beispiel auf das korrekte Einstecken von Steckern oder eine informationstechnische Kommunikation mit diesen über Kontakte oder NFC-Chips oder dergleichen.

### Bezugszeichen:

- 10: Buchsenanordnung
- 11: Öffnung
- 12: Buchsengehäuse
- 13: Oberer Gehäuseteil des Buchsengehäuses 12
- 14: Unterer Gehäuseteil des Buchsengehäuses 12
- 15: Trennlinie zwischen den Gehäuseteilen 13, 14
- 16: Innenraum des Buchsengehäuses 12
- 17, 18: Führungskörper
- 19: Rückseite
- 20: Anschlussöffnung
- 21: Funktionselement
- 22, 22': Buchseneinsatz
- 23: Isoliermaterial
- 24 - 27: Biegestellen
- 28: Buchsenanschlüsse
- 29 - 32: Leiterzüge
- 33: Dosenkontakte
- L1 - L4: Leiterebenen
- 34: Elektrisches Bauelement
- 35: Steckkontaktfelder
- 36 - 39: Kontaktelemente
- 40 - 42: Durchbrüche
- 43: Nut
- 44, 45: Flachseiten des Isoliermaterials
- B1 - B5: Bereiche des Isoliermaterials bzw. des Buchseneinsatzes 22

## Patentansprüche

1. Buchsenanordnung (10), insbesondere für medizinische Geräte,
wobei die Buchsenanordnung (10) ein Buchsengehäuse (12) und einen Buchseneinsatz (22) aufweist, der von dem Buchsengehäuse (12) aufgenommen ist,
**dadurch gekennzeichnet, dass**
der Buchseneinsatz (22) aus einem flächigen, an dazu vorgesehenen Biegestellen (24 - 27) gefalteten Isoliermaterial (23) mit darauf und/oder darin angeordneten elektrischen Leitern (29 - 32) besteht.

2. Buchsenanordnung nach Anspruch 1, **dadurch gekennzeichnet, dass** die Biegestellen (24 - 27) linienförmige Bereiche sind.

3. Buchsenanordnung nach Anspruch 1 oder 2, **dadurch gekennzeichnet, dass** die Biegestellen (24 - 27) entlang von Geraden verlaufend ausgebildet sind.

4. Buchsenanordnung nach einem der vorstehenden Ansprüche, **dadurch gekennzeichnet, dass** an dem Isoliermaterial (23) wenigstens zwei linienförmige, zueinander parallele Biegestellen (24 - 26) vorgesehen sind.

5. Buchsenanordnung nach einem der vorstehenden Ansprüche, **dadurch gekennzeichnet, dass** der Buchseneinsatz (22) in dem Buchsengehäuse (12) unbeweglich gehalten ist.

6. Buchsenanordnung nach einem der vorstehenden Ansprüche, **dadurch gekennzeichnet, dass** das Isoliermaterial (23) als steife Platte mit mehreren durch die Biegestellen (24 - 27) miteinander verbundenen Bereichen (B1 - B5) ausgebildet ist.

7. Buchsenanordnung nach einem der vorstehenden Ansprüche, **dadurch gekennzeichnet, dass** das Isoliermaterial (23) ein Kunststoffmaterial, vorzugsweise ein Kunststoff-Kompositmaterial ist.

8. Buchsenanordnung nach einem der vorstehenden Ansprüche, **dadurch gekennzeichnet, dass** die Biegestellen (24 - 27) durch in dem Isoliermaterial (23) ausgebildete Nuten (43) gebildet sind.

9. Buchsenanordnung nach Anspruch 8, **dadurch gekennzeichnet, dass** die Nuten (43) zu einem von dem Isoliermaterial (23) umschlossenen Innenraum (16) hin offen sind.

10. Buchsenanordnung nach einem der vorstehenden Ansprüche, **dadurch gekennzeichnet, dass** der Buchseneinsatz (22) einen Innenraum (16) wenigstens dreiseitig umschließt,

11. Buchsenanordnung nach einem der vorstehenden Ansprüche, **dadurch gekennzeichnet, dass** der Buchseneinsatz (22) an den Biegestellen (24 - 27) elastisch verformbar ist.

12. Buchsenanordnung nach einem der vorstehenden Ansprüche, **dadurch gekennzeichnet, dass** das Isoliermaterial (23) des Buchseneinsatzes (22) nahtlos einstückig ausgebildet ist.

13. Buchsenanordnung nach einem der vorstehenden Ansprüche, **dadurch gekennzeichnet, dass** die Biegestellen (24 - 27) durch einen flexiblen Leiterträger, der an den Biegestellen (24 - 27) voneinander separierte Bereiche (B1 - B5) des Isoliermaterials (23) miteinander mechanisch und/oder elektrisch verbindet, gebildet sind.

14. Buchsenanordnung nach einem der vorstehenden Ansprüche, **dadurch gekennzeichnet, dass** an dem Isoliermaterial (23) wenigstens ein Kontaktkörper (37) gehalten ist.

15. Buchsenanordnung nach einem der vorstehenden Ansprüche, **dadurch gekennzeichnet, dass** das Isoliermaterial (23) wenigstens eine Aussparung (40) aufweist und dass an dem Buchsengehäuse (12) wenigstens ein Führungskörper (18) angeordnet ist, der die Aussparung (40) durchragend angeordnet ist.
